# EUROPÄISCHE PATENTSCHRIFT

(11) **EP 1 132 683 B1**
(45) Veröffentlichungstag und Bekanntmachung des Hinweises auf die Patenterteilung: **25.10.2006**
(21) Anmeldenummer: 01104689.3
(22) Anmeldetag: 26.02.2001
(51) Int. Cl.: F21V 23/00, H05K 5/02, H05B 41/02

(54) **Elektrisches Gerät sowie Baueinheit aus einem elektrischen Gerät und einer Lampenwanne**
Electrical apparatus, component of an electrical apparatus and a lamp fixture
Appareil électrique, composant d'un appareil électrique et d'une armature de lampe

(30) Priorität: 07.03.2000 DE 10010356
(43) Veröffentlichungstag der Anmeldung: 12.09.2001
(73) Patentinhaber: PHOENIX CONTACT GmbH & Co. Kg, 32825 Blomberg (DE); Patent-Treuhand-Gesellschaft für elektrische Glühlampen mbH, 81543 München (DE)
(72) Erfinder: Feye-Hohmann, Jürgen, 32756 Detmold (DE); Ebert, Wolfgang, 83308 Trostberg (DE); Löhmann, Gunther, Dr.-Ing., 88239 Wangen (DE)
(74) Vertreter: Gesthuysen, von Rohr & Eggert

(56) Entgegenhaltungen:
- EP-A- 0 769 833
- DE-U- 7 138 560
- FR-A- 2 530 396
- US-A- 5 086 249
- US-A- 5 350 316
- US-A- 5 691 878

## Beschreibung

Die Erfindung betrifft ein elektrisches Gerät, insbesondere ein Vorschaltgerät für Leuchtstofflampen, sowie eine Baueinheit aus einem elektrischen Gerät und einer Lampenwanne.

Vorschaltgeräte für Leuchtstofflampen, heutzutage typischerweise als elektronische Vorschaltgeräte ausgebildet, werden bisher im allgemeinen von Hand an die Leuchtstofflampen angebaut, also z. B. in der Lampenwanne montiert. Zur Montage eines solchen elektronischen Vorschaltgeräts ist in dessen Gehäuse typischerweise ein Langloch ausgestanzt, so daß das Gehäuse des elektronischen Vorschaltgeräts mit Hilfe von Schrauben und Muttern oder mit Hilfe von Nieten, die durch das Langloch hindurchgeführt werden, in der Lampenwanne befestigt wird. Im allgemeinen ist es dabei erforderlich, das Gehäuse des elektronischen Vorschaltgeräts sowie eine in diesem vorgesehene Leiterplatine zu erden, wobei die Leiterplatine als Anschlußelement typischerweise eine Anschlußklemme mit einer Mehrzahl von Anschlußklemmstellen aufweist. Eine Erdung kann dabei z. B. in Form einer elektrisch leitenden Verbindung zwischen dem Gehäuse des elektronischen Vorschaltgeräts und der Lampenwanne durch einen separaten Kabelanschluß erfolgen, wobei die Leiterplatine dann typischerweise mit Hilfe einer an dieser vorgesehenen Anschlußklemmstelle über das Gehäuse des elektronischen Vorschaltgeräts ebenfalls geerdet ist. Eine andere Möglichkeit der Erdung des Gehäuses des elektronischen Vorschaltgeräts sowie der Leiterplatine besteht darin, beim Aufschrauben der Muttern auf die Befestigungsschrauben Zahnscheiben zu verwenden, die eine eventuell auf dem Wannenboden der Lampenwanne oder auf einer Seitenfläche des Gehäuses vorhandene Oxid- oder Lackschicht sicher durchtrennt, so daß auf diese Weise ein guter elektrischer Kontakt für die Erdung durch die Schraubbefestigung selbst gewährleistet.

Bei dieser Art der Montage eines elektrischen Vorschaltgeräts in einer Lampenwannen sind der hohe manuelle Montageaufwand und die Ungenauigkeiten bei der Positionierung der einzelnen Anschlußklemmstellen der Anschlußklemme relativ zum Gehäuse des elektronischen Vorschaltgeräts sowie relativ zur Lampenwanne nachteilig. Dies führt insbesondere dann zu Problemen, wenn die Verdrahtung der Leuchtstofflampen, also der Anschluß einzelner Adern eines oder mehrerer Kabel an den Anschlußklemmstellen mit Hilfe eines Verlegeautomaten durchgeführt werden soll. Sind dabei nämlich die Anschlußklemmstellen ungenau positioniert, kommt es häufig zu Fehlsteckungen der einzelnen Adern in den Anschlußklemmstellen. Um dies zu vermeiden, kann z. B. ein optisches Mustererkennungssystem eingesetzt werden, das Positionsungenauigkeiten der Anschlußklemmstellen erkennt und entsprechend korrigiert. Der Einsatz eines solchen optischen Mustererkennungssystems ist jedoch sehr aufwendig und dementsprechend teuer.

Selbst wenn das Gehäuse des elektronischen Vorschaltgeräts dadurch relativ genau positioniert wird, daß z. B. eine Begrenzung des Langlochs in dem Gehäuse des elektronischen Vorschaltgeräts als Anschlag dient und somit als örtliche Bezugsbasis verwendet wird, ist die Ortsgenauigkeit einer jeweiligen Anschlußklemmstelle von einer Mehrzahl von Toleranzen, wie z. B. der Ortstoleranz der Anschlußklemmstellen auf der Anschlußklemme, der Ortstoleranz der Anschlußklemme auf der Leiterplatine, der Ortstoleranz der Leiterplatine in dem Gehäuse des elektronischen Vorschaltgeräts, der Ortstoleranz der Befestigung des Gehäuses des elektronischen Vorschaltgeräts in der Lampenwanne selbst usw. bestimmt, wobei sich die Beträge dieser Toleranzen im ungünstigsten Fall vollständig aufeinander aufaddieren. Schlimmstenfalls kommt es dabei zu einer solchen örtlichen Verschiebung der einzelnen Anschlußklemmstellen, die wenigstens dem halben Abstand zwischen zwei einander benachbarten Anschlußklemmstellen entspricht oder sogar noch darüber hinausgeht, so daß in diesem Fall bei der Verdrahtung der Leuchtstofflampe mittels eines Verlegeautomaten Fehlsteckungen unausweichlich sind.

Ein Vorschaltgerät ist im Dokument US 5 350 316 A offenbart.

Es ist nun die Aufgabe der Erfindung, ein elektrisches Gerät, insbesondere ein Vorschaltgerät für Leuchtstofflampen, sowie eine Baueinheit aus einem solchen elektrischen Gerät und einer Lampenwanne anzugeben, bei dem bzw. bei der die einzelnen Anschlußklemmstellen der Anschlußklemme nur eine geringe Ortstoleranz aufweisen, so daß z. B. die Verdrahtung mit einem Verlegeautomaten ohne die Gefahr von Fehlsteckungen möglich ist.

Das erfindungsgemäße elektrische Gerät, insbesondere Vorschaltgerät für Leuchtstofflampen, in Anspruch 1 definiert, bei dem die zuvor hergeleitete und aufgezeigte Aufgabe gelöst ist, ist zunächst.

Erfindungsgemäß wirkt somit das Rastelement praktisch als Zwischenstück zwischen der Anschlußklemme und dem Gehäuse, wobei vorzugsweise die Verbindung der Anschlußklemme mit dem Rastelement einerseits und die Verbindung des Rastelements mit dem Gehäuse andererseits jeweils immer mit Hilfe desselben Rastschenkels erfolgt. Insofern besteht bei der Befestigung der Anschlußklemme in dem Gehäuse lediglich ein einziger Bezugspunkt, nämlich der Befestigungsort des Rastschenkels an dem Rastelement. Somit wird die im Stand der Technik vorhandene Kette von Toleranzen, die sich im schlimmsten Fall vollständig aufeinander aufaddieren, vermieden, so daß die Genauigkeit der örtlichen Lage der einzelnen Anschlußklemmstellen der Anschlußklemme relativ zum Gehäuse sehr gut ist.

Gemäß der Erfindung ist vorgesehen, daß beide Seitenwänden des Gehäuses jeweils eine Ausnehmung aufweisen und Rastschenkel des Rastelements in dieser Ausnehmungen eingerastet sind. Um die oben angesprochenen Ortsungenauigkeiten der Anschlußklemmstellen so gering wie möglich zu halten, wird dabei vorzugsweise derart vorgegangen, daß die Größe der Ausnehmung in der Seitenwand des Gehäuses genau an die Größe des in die Ausnehmung einrastenden Bereichs des Rastschenkels angepaßt ist, der in der Ausnehmung eingerastete Rastschenkel somit praktisch kein Spiel mehr aufweist.

Im allgemeinen handelt es sich bei den Gehäusen um solche Gehäuse, die zwei einander parallel gegenüberliegende Seitenwände aufweisen. Im allgemeinen besteht die Erfindung darin, daß das Rastelement genau zwei, vorzugsweise ebenfalls einander parallel gegenüberliegende Rastschenkel aufweist, in den beiden Seitenwänden des Gehäuses jeweils eine Ausnehmung vorgesehen ist und die beiden Rastschenkel jeweils in eine dieser Ausnehmungen eingerastet sind. Für diese Konstruktion gilt ebenfalls, daß die Größe der Ausnehmungen vorzugsweise genau an die Größe des in die Ausnehmungen einrastenden Bereichs der Rastschenkel angepaßt ist, so daß letztendlich das in dem Gehäuse eingerastete Rastelement praktisch kein Spiel mehr aufweist.

Die Befestigung der Anschlußklemme in dem Rastelement erfolgt gemäß einer bevorzugten Weiterbildung der Erfindung dadurch, daß zwei Rastschenkel vorgesehen sind, beide Rastschenkel jeweils eine nach innen weisende Nase aufweisen, die entweder den Boden der Anschlußklemme, der typischerweise von einer Leiterplatine gebildet wird, oder einen anderen dafür geeigneten Bereich der Anschlußklemme jeweils seitlich übergreifen, so daß eine Einrastung der Anschlußklemme erfolgt. Um die Anschlußklemme in dem Rastelement zu befestigen, ist es somit erforderlich, daß die beiden Rastschenkel beim Eindrücken der Anschlußklemme in das Rastelement nach außen ausweichen können, um dann, sobald die Anschlußklemme tief genug in das Rastelement eingesteckt worden ist, über dessen Boden wieder zuzuschnappen.

Gemäß einer bevorzugten Weiterbildung der Erfindung ist vorgesehen, daß das Rastelement zwei Seitenwände aufweist, die beiden Rastschenkel jeweils an einer Seitenwand des Rastelements vorgesehen sind und die Seitenwände an der Vorderseite des Rastelements mit einer Vorderwand miteinander verbunden sind. Dabei ist dann vorzugsweise die Rückseite des Rastelements offen. Das ist insbesondere auch insofern vorteilhaft, als daß die Leiterplatine die mit der Anschlußklemme verbunden ist bzw. an der die Anschlußklemme befestigt ist, auf diese Weise nicht durch die Größe des Rastelements beschränkt ist und deutlich nach hinten über das Rastelement hinausreichen kann. Vorzugsweise ist das Rastelement im übrigen mit einem Boden versehen. Schließlich besteht bei dem erfindungsgemäßen elektrischen Gerät das Rastelement in aller Regel aus einem elektrisch nicht leitendem Material, insbesondere aus Kunststoff.

Bei der zuletzt beschriebenen bevorzugten Ausführungsform eines erfindungsgemäßen elektrischen Gerätes kann die Vorderwand und/oder der Boden des Rastelements als Untersteckschutz dienen. Dieser Untersteckschutz führt im wesentlichen dazu, daß eine Isolierung zwischen den Anschlußklemmstellen bzw. den an den Anschlußklemmstellen angeschlossenen elektrischen Leitern auch dann gewährleistet ist, wenn z. B. ein Metallteil, wie eine Schraube, zwischen die Anschlußklemme und den Boden bzw. die Seitenwände des Gehäuses gerät oder sich eine elektrische Leitung von einer Anschlußklemmstelle löst. Eine Isolierung des Innenbereichs des Gehäuses kann darüber hinaus dadurch erzielt werden, daß die Innenseiten des Gehäuses und/oder der Gehäuseboden mit einer elektrisch isolierenden Folie bedeckt sind.

Eine erfindungsgemäße Baueinheit aus einem elektrischen Gerät, insbesondere einem erfindungsgemäßen elektrischen Gerät, und einer mit einem Wannenboden versehenen Lampenwanne ist zunächst und im wesentlichen dadurch gekennzeichnet, daß im Gehäuseboden des elektrischen Gerätes ein Schlitz vorgesehen ist, der Wannenboden der Lampenwanne eine Rastlasche aufweist und die Rastlasche in dem Schlitz verrastet ist. Eine besonders vorteilhafte Weiterbildung dieser Baueinheit ergibt sich insbesondere dadurch, daß die Anschlußklemme mittels des oben beschriebenen Rastelements in dem Gehäuse befestigt ist. Sind dabei in den Seitenwänden des Gehäuses die oben beschriebenen Ausnehmungen vorgesehen, so sind die Ausnehmungen in den Seitenwänden des Gehäuses und der Schlitz in dem Gehäuseboden vorzugsweise in einem einzigen Stanzvorgang und dabei mit einem einzigen Stanzwerkzeug ausgestanzt worden. Auf diese Weise erzielt man zwischen den Ausnehmungen in den Seitenwänden des Gehäuses einerseits und dem Schlitz im Gehäuseboden andererseits geringstmögliche Abstandstoleranzen, so daß im Ergebnis durch ein paßgenaues Einstecken und Einrasten des Gehäuses auf die Rastlasche auf dem Wannenboden der Lampenwanne eine optimale Positionierung des Gehäuses mit montierter Anschlußklemme auf der Lampenwanne mit minimalen Ortstoleranzen erzielt wird.

Gemäß einer bevorzugten Weiterbildung der zuvor beschriebenen erfindungsgemäßen Baueinheit sind die Rastlasche und der Wannenboden der Lampenwanne einstückig ausgebildet. Vorzugsweise ist nämlich vorgesehen, daß die Rastlasche aus dem Wannenboden der Lampenwanne teilweise ausgestanzt und herausgebogen ist. Das heißt, daß die Rastlasche aus der Lampenwanne ausgestanzt wird, so daß der herausgestanzte Bereich, der die Rastlasche bilden soll, aus der Ebene des Bodens der Lampenwanne herausgebogen werden kann, so daß die Rastlasche vorzugsweise in einem Winkel von 90° relativ zum Wannenboden der Lampenwanne emporsteht. Zur Verrastung weist die Rastlasche vorzugsweise mindestens eine federnde Rastzunge auf, die leicht aus der Ebene der Rastlasche herausgebogen ist. Beim Einstecken der Rastlasche in den in dem Gehäuseboden vorgesehenen Schlitz federt dieser Bereich in die Ebene der Rastlasche zurück, so daß das Gehäuse auf die Rastlasche aufgeschoben werden kann, und verhindert ein Abnehmen oder Zurückrutschen des Gehäuses im vollständig aufgeschobenen und somit eingerasteten Zustand des Gehäuses.

Eine erfindungsgemäße Baueinheit aus einem elektrischen Gerät, insbesondere einem erfindungsgemäßen elektrischen Gerät, und einer mit einem Wannenboden versehenen Lampenwanne ist im übrigen, losgelöst von den zuvor beschriebenen Maßnahmen, dadurch gekennzeichnet, daß der Wannenboden der Lampenwanne einen emporstehenden Erdungsstachel aus einem elektrische leitenden Material aufweist und der Erdungsstachel mit einem Erdungsanschluß der Anschlußklemme verbunden ist. Auf diese Weise wird eine sehr einfache und verläßliche Erdung der Anschlußklemme und, bei einer entsprechenden Verbindung der Anschlußklemme mit dem Gehäuse, auch des Gehäuses erzielt, die automatisch beim Anbringen, also insbesondere beim Aufstecken des Gehäuses auf die Lampenwanne realisiert wird. Eine besonders einfache Ausgestaltung des Erdungsstachels ergibt sich dadurch, daß der Erdungsstachel und der Wannenboden der Lampenwanne einstückig ausgebildet sind und der Erdungsstachel aus dem Wannenboden der Lampenwanne teilweise ausgestanzt und herausgebogen ist. Dabei kann der Erdungsstachel seitlich an dem Gehäuse vorbeigeführt sein, um in Kontakt mit der Anschlußklemme zu kommen. Eine bevorzugte Ausführungsform ist jedoch dadurch gekennzeichnet, daß der Erdungsstachel mit dem Gehäuse, insbesondere mit dem Gehäuseboden des Gehäuses, elektrisch verbunden ist. Schließlich ist eine weitere bevorzugte Ausführungsform der erfindungsgemäßen Baueinheit dadurch gekennzeichnet, daß der Erdungsstachel elektrisch leitend durch eine im Gehäuseboden des Gehäuses vorgesehene Ausnehmung hindurchgeführt ist.

Im einzelnen gibt es nun eine Vielzahl von Möglichkeiten, das erfindungsgemäße elektrische Gerät und die erfindungsgemäße Baueinheiten auszugestalten und weiterzubilden. Dazu wird auf die den unabhängigen Patentansprüchen nachgeordneten Patentansprüche sowie auf die nachfolgende detaillierte Beschreibung bevorzugter Ausführungsbeispiele der Erfindung unter Bezugnahme auf die Zeichnung verwiesen. In der Zeichnung zeigt:
- Fig. 1: ein bevorzugtes Ausführungsbeispiel eines erfindungsgemäßen elektrischen Gerätes, in noch nicht zusammengesetztem Zustand,
- Fig. 2: das elektrische Gerät nach Fig. 1, in zusammengesetztem Zustand,
- Fig. 3: das Rastelement des elektrischen Gerätes nach Fig. 1, in einer rückwärtigen Ansicht,
- Fig. 4: ein erstes bevorzugtes Ausführungsbeispiel einer erfindungsgemäßen Baueinheit aus dem elektrischen Gerät nach den Fig. 1 und 2 und einer - nur ausschnittsweise angedeuteten - Lampenwanne und
- Fig. 5: ein zweites bevorzugtes Ausführungsbeispiel einer erfindungsgemäßen Baueinheit aus dem elektrischen Gerät nach den Fig. 1 und 2 und einer - nur ausschnittsweise angedeuteten - Lampenwanne.

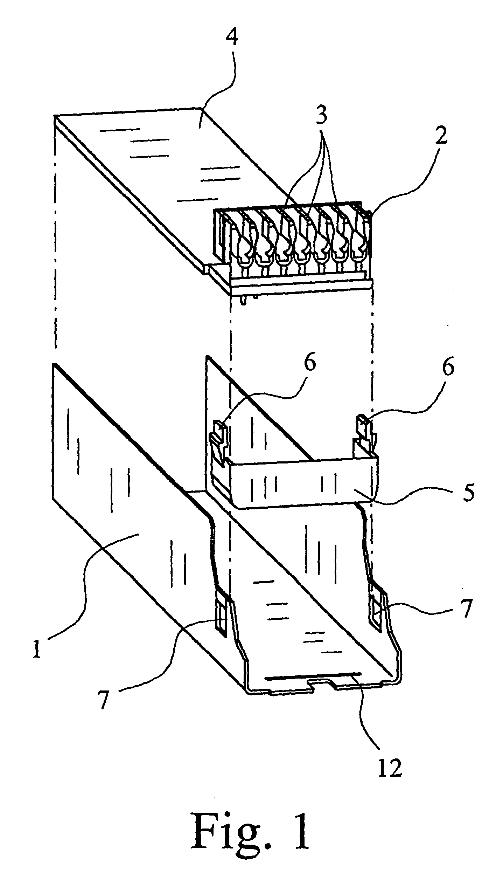

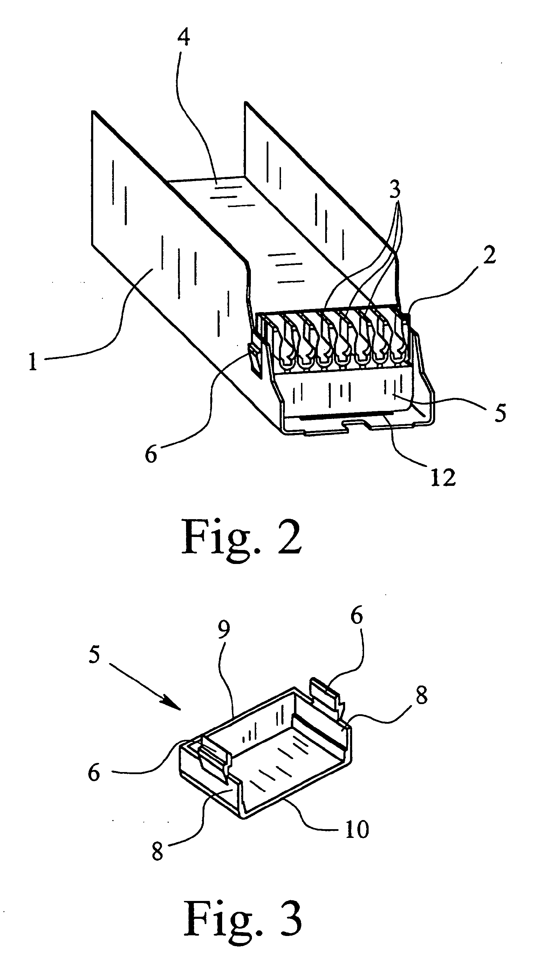

Aus Fig. 1 ist ein elektrisches Gerät, nämlich ein Vorschaltgerät für eine Leuchtstofflampe, gemäß einem bevorzugten Ausführungsbeispiel der Erfindung in einem noch nicht zusammengesetzten Zustand ersichtlich. Das elektrische Gerät weist ein Gehäuse 1 auf, in dem eine Anschlußklemme 2 befestigt werden soll. Die Anschlußklemme 2 weist Anschlußklemmstellen 3 auf und ist auf einer Leiterplatine 4 angeordnet. Die Befestigung der Anschlußklemme 2 in dem Gehäuse 1 erfolgt mit Hilfe eines Rastelements 5, das praktisch als Zwischenstück zwischen dem Gehäuse 1 einerseits und der Anschlußklemme 2 andererseits wirkt. Das Rastelement 5 weist Rastschenkel 6 auf, die, wie z. B. aus Fig. 2 ersichtlich, genau in in den Seitenwänden des Gehäuses 1 vorgesehene Ausnehmungen 7 passen und im eingebauten Zustand des Rastelements 5 in den Ausnehmungen 7 eingerastet sind. Die Rastschenkel 6 sind an zueinander parallelen Seitenwänden 8 des Rastelements 5 vorgesehen, so daß die Rastschenkel 6 ebenfalls einander parallel gegenüberstehen. Die Seitenwände 8 des Rastelements 5 sind miteinander verbunden, indem die Vorderseite des Rastelements 5 mittels einer Vorderwand 9 geschlossen ist. Wie aus Fig. 3 ersichtlich, weist das Rastelement 5 einen Boden 10 auf, so daß für die Anschlußklemme 2 eine isolierende Trennung zum Boden des Gehäuses 1 besteht.

Beim Zusammenbau des elektrischen Gerätes aus dem Gehäuse 1, der Anschlußklemme 2 und dem Rastelement 5 wird derart vorgegangen, daß zuerst in das Gehäuse 1 eine nicht weiter dargestellte Folie aus einem elektrisch isolierenden Material eingelegt wird, dann das Rastelement 5 in das Gehäuse 1 eingerastet wird und schließlich die Anschlußklemme 2 - mit der Leiterplatine 4 - in das Rastelement 5 eingerastet wird. Das Rastelement 5 ist aus einem elastischen Kunststoff hergestellt, so daß einerseits Bewegungen der Rastschenkel 6 nach innen bzw. nach außen zugelassen sind, was wesentlich für die Rastfunktion der Rastschenkel 6 ist, und daß andererseits die Seitenwände 8, die Vorderwand 9 und der Boden 10 des Rastelements 5 einen Isolierschutz bilden, insbesondere auch einen Untersteckschutz.

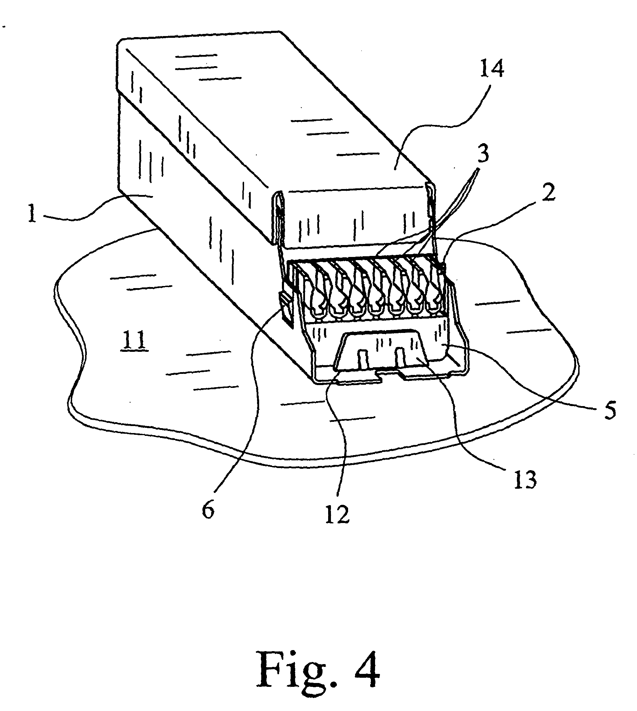

Aus Fig. 4 ist ersichtlich, wie das elektrische Gerät nach den Fig. 1 und 2 auf dem Wannenboden 11 einer nicht weiter dargestellten Lampenwanne montiert ist. Für diese Montage ist in dem Gehäuseboden des Gehäuses 1 ein Schlitz 12 vorgesehen, in den eine von dem Wannenboden 11 der Lampenwanne senkrecht nach oben stehende Rastlasche 13 genau passend eingerastet ist. Wie oben schon ausgeführt, wird auf diese Weise eine sehr genaue Positionierung der Anschlußklemme 2 mit ihren Anschlußklemmstellen 3 auch relativ zur Lampenwanne erzielt. Im fertig in der Lampenwanne montierten Zustand ist das Gehäuse 1 mittels eines Deckels 14 verschlossen.

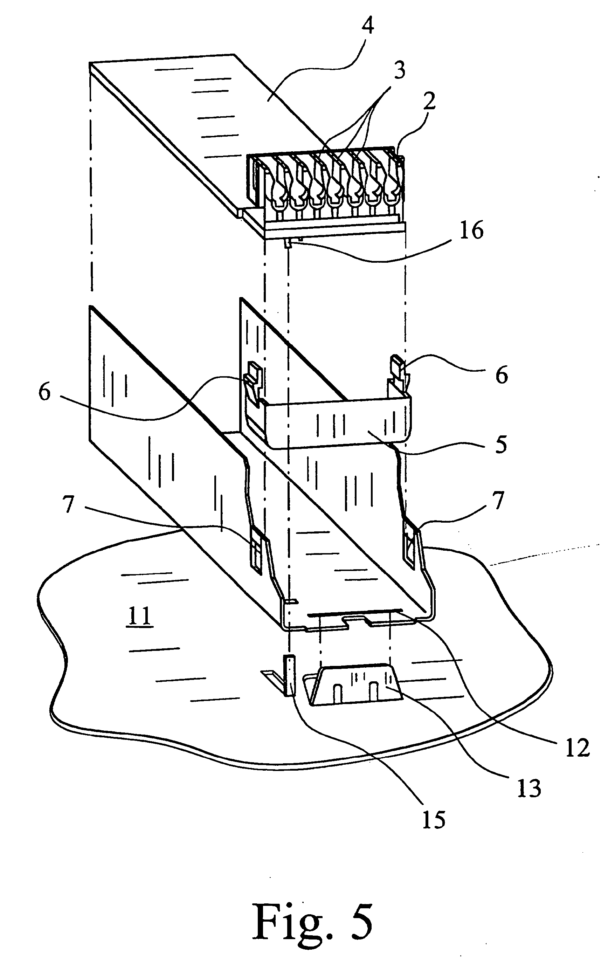

Aus Fig. 5 ist ersichtlich, daß ein senkrecht vom Wannenboden 11 der Lampenwanne nach oben stehender Erdungsstachel 15 zur Verbindung mit einem Erdungsanschluß 16 der Anschlußklemme 2 vorgesehen ist. Nicht dargestellt ist, daß der Erdungsanschluß 16 als Schneidkontakt ausgeführt ist, so daß beim Zusammenführen des Erdungsstachels 15 mit dem Erdungsanschluß 16 dieser mit seinem Schneidkontakt durch die Oberfläche des Erdungsstachels 15 hindurchdringt, wodurch ein sicherer Kontakt von Metall zu Metall gewährleistet wird, selbst dann, wenn die Oberfläche des Erdungsstachels 15 beschichtet ist. Da eine besonders einfache Herstellung des von dem Wannenboden 11 der Lampenwanne senkrecht nach oben stehenden Erdungsstachels 15 durch Ausstanzen und teilweises Herausbiegen des Erdungsstachels 15 aus dem Wannenboden 11 der Lampenwanne erzielt wird, wird der Erdungsstachel 15 auch nicht um das Gehäuse 1 herumgeführt, was einen abgewinkelten Verlauf des Erdungsstachels 15 erfordern würde. Statt dessen wird der Erdungsstachel 15 durch eine im Gehäuse 1 vorgesehene Ausnehmung sowie eine in dem Rastelement 5 vorgesehene Ausnehmung hindurchgeführt. Grundsätzlich ist außerdem eine Kontaktierung des Erdungsstachels 15 mit dem Gehäuse 1 im Bereich der Ausnehmung in dem Gehäuse 1 möglich. Eine zuverlässiger Erdung des Gehäuses 1 kann jedoch auch dadurch erzielt werden, daß das Gehäuse 1 separat mit dem Erdungsanschluß 16 der Anschlußklemme 2 verbunden ist.

## Patentansprüche

1. Elektrisches Gerät, insbesondere Vorschaltgerät für Leuchtstofflampen, mit einem zwei zueinander parallele Seitenwände ausweisenden Gehäuse (1) und mit einer Anschlußklemme (2) mit mehreren Anschlußklemmstellen (3) zum Anschließen mehrerer Adern,
**dadurch gekennzeichnet,**
**daß** ein Rastelement (5) vorgesehen ist, daß das Rastelement (5) zwei Rastschenkel (6) aufweist und die Anschlußklemme (2) in dem Gehäuse (1) mittels des Rastelements (5) befestigt ist, die Anschlußklemme (2) nämlich mittels der Rastschenkel (6) mit dem Rastelement (5) und das Rastelement (5) mittels derselben Rastschenkel (6) mit dem Gehäuse (1) verbunden ist,
wobei in den beiden Seitenwänden des Gehäuses (1) jeweils eine Ausnehmung (7) vorgesehen ist und die beiden Rastschenkel (6) jeweils in einer Ausnehmung (7) eingerastet sind.

2. Elektrisches Gerät nach Anspruch 1, **dadurch gekennzeichnet, daß** die Anschlußklemme (2) einen Boden aufweist, der Rastschenkel (6) des Rastelementes (5) eine nach innen weisende Nase aufweist und der Boden der Anschlußklemme (2) von der Nase des Rastschenkels (6) seitlich übergriffen ist.

3. Elektrisches Gerät nach Anspruch 1 oder 2, **dadurch gekennzeichnet, daß** beide Rastschenkel (6) jeweils eine nach innen weisende Nase aufweisen und der Boden der Anschlußklemme (2) von den Nasen der Rastschenkel (6) seitlich übergriffen ist.

4. Elektrisches Gerät nach einem der Ansprüche 1 bis 3, **dadurch gekennzeichnet, daß** das Rastelement (5) zwei Seitenwände (8) aufweist, die beiden Rastschenkel (6) jeweils an einer Seitenwand (8) des Rastelements (5) vorgesehen sind und die Seitenwände (8) an der Vorderseite des Rastelements (5) mit einer Vorderwand (9) miteinander verbunden sind.

5. Elektrisches Gerät nach Anspruch 4, **dadurch gekennzeichnet, daß** die Rückseite des Rastelements (5) offen ist.

6. Elektrisches Gerät nach Anspruch 4 oder 5, **dadurch gekennzeichnet, daß** das Rastelement (5) einen Boden (10) aufweist.

7. Elektrisches Gerät nach einem der Ansprüche 1 bis 6, **dadurch gekennzeichnet, daß** das Rastelement (5) aus einem elektrisch nicht leitendem Material besteht, insbesondere aus Kunststoff.

8. Elektrisches Gerät nach einem der Ansprüche 4 bis 7, **dadurch gekennzeichnet, daß** die Vorderwand (9) und/oder der Boden (10) des Rastelements (5) als Untersteckschutz dienen bzw, dient.

9. Elektrisches Gerät nach einem der Ansprüche 1 bis 8, **dadurch gekennzeichnet, daß** die Innenseiten des Gehäuses (1) und/oder der Gehäuseboden mit einer elektrisch isolierenden Folie bedeckt sind.

10. Baueinheit aus einem elektrischen Gerät nach einem der Ansprüche 1 bis 9, insbesondere einem Vorschaltgerät für Leuchtstofflampen, mit einem zwei zueinander parallele Seitenwände aufweisenden Gehäuse (1) und mit einer Anschlußklemme, (2) mit mehreren Anschlußklemmstellen (3) zum Anschließen mehrerer Adern, und einer mit einem Wannenboden (11) versehenen Lampenwanne, **dadurch gekennzeichnet, daß** im Gehäuseboden des elektrischen Gerätes ein Schlitz (12) vorgesehen ist, der Wannenboden (11) der Lampenwanne eine Rastlasche (13) aufweist und die Rastlasche (13) in dem Schlitz (12) verrastet ist.

11. Elektrisches Gerät nach Anspruch 10, **dadurch gekennzeichnet, daß** die Rastlasche (13) und der Wannenboden (11) der Lampenwanne einstückig ausgebildet sind.

12. Elektrisches Gerät nach Anspruch 10 oder 11, **dadurch gekennzeichnet, daß** die Rastlasche (13) mit mindestens einer federnden Rastzunge versehen ist.

13. Baueinheit aus einem elektrischen Gerät nach einem der Ansprüche 1 bis 9, insbesondere einem Vorschaltgerät für Leuchtstofflampen, mit einem zwei zueinander parallele Seitenwände aufweisenden Gehäuse (1) und mit einer Anschlußklemme (2) mit mehreren Anschlußklemmstellen (3) zum Anschließen mehrerer Adern, und einer mit einem Wannenboden (11) versehenen Lampenwanne, insbesondere nach einem der Ansprüche 10 bis 12, **dadurch gekennzeichnet, daß** der Wannenboden (11) der Lampenwanne einen empor stehenden Erdungsstachel (15) aus einem elektrisch leitenden Material aufweist und der Erdungsstachel (15) mit einem Erdungsanschluß (16) der Anschlußklemme (2) verbunden ist.

14. Baueinheit nach Anspruch 13, **dadurch gekennzeichnet, daß** der Erdungsanschluß (16) der Anschlußklemme (2) als Schneidkontakt ausgeführt ist.

15. Baueinheit nach Anspruch 13 oder 14, **dadurch gekennzeichnet, daß** der Erdungsstachel (15) und der Wannenboden (11) der Lampenwanne einstückig ausgebildet sind und der Erdungsstachel (15) aus dem Wannenboden (11) der Lampenwanne teilweise ausgestanzt und herausgebogen ist.

16. Baueinheit nach einem der Ansprüche 13 bis 15, **dadurch gekennzeichnet, daß** der Erdungsstachel (15) mit dem Gehäuse (1), insbesondere mit dem Gehäuseboden des Gehäuses (1), elektrisch verbunden ist.

17. Baueinheit nach Anspruch 16, **dadurch gekennzeichnet, daß** der Erdungsstachel (15) elektrisch leitend durch eine im Gehäuseboden des Gehäuses (1) vorgesehene Ausnehmung hindurchgeführt ist.

## Claims

1. Electrical device, in particular ballast for fluorescent lamps, having a housing (1), which has two parallel side walls, and having a connection terminal (2) having a plurality of terminal connections (3) for connecting a plurality of wires, **characterized in that** a latching element (5) is provided, **in that** the latching element (5) has two latching limbs (6) and the connection terminal (2) is fixed in the housing (1) by means of the latching element (5), that is to say the connection terminal (2) is connected to the latching element (5) by means of the latching limbs (6), and the latching element (5) is connected to the housing (1) by means of the same latching limbs (6), in each case one cutout (7) being provided in the two side walls of the housing (1), and the two latching limbs (6) each being latched into one cutout (7).

2. Electrical device according to Claim 1, **characterized in that** the connection terminal (2) has a base, the latching limb (6) of the latching element (5) has an inwardly pointing tab, and the base of the connection terminal (2) is overlapped laterally by the tab of the latching limb (6).

3. Electrical device according to Claim 1 or 2, **characterized in that** the two latching limbs (6) each have an inwardly pointing tab, and the base of the connection terminal (2) is overlapped laterally by the tabs of the latching limbs (6).

4. Electrical device according to one of Claims 1 to 3, **characterized in that** the latching element (5) has two side walls (8), the two latching limbs (6) are each provided on one side wall (8) of the latching element (5), and the side walls (8) are connected to one another at the front side of the latching element (5) by a front wall (9).

5. Electrical device according to Claim 4,
**characterized in that** the rear side of the latching element (5) is open.

6. Electrical device according to Claim 4 or 5, **characterized in that** the latching element (5) has a base (10).

7. Electrical device according to one of Claims 1 to 6, **characterized in that** the latching element (5) consists of an electrically nonconductive material, in particular consists of plastic.

8. Electrical device according to one of Claims 4 to 7, **characterized in that** the front wall (9) and/or the base (10) of the latching element (5) act(s) as under-plugging protection.

9. Electrical device according to one of Claims 1 to 8, **characterized in that** the inner sides of the housing (1) and/or the housing base are covered by an electrically insulating foil.

10. Unit comprising an electrical device according to one of Claims 1 to 9, in particular a ballast for fluorescent lamps, having a housing (1), which has two parallel side walls, and having a connection terminal (2) having a plurality of terminal connections (3) for connecting a plurality of wires and a lamp trough provided with a trough base (11), **characterized in that** a slot (12) is provided in the housing base of the electrical device, the trough base (11) of the lamp trough has a latching lug (13), and the latching lug (13) is latched in the slot (12).

11. Electrical device according to Claim 10, **characterized in that** the latching lug (13) and the trough base (11) of the lamp trough are of integral design.

12. Electrical device according to Claim 10 or 11, **characterized in that** the latching lug (13) is provided with at least one resilient latching tongue.

13. Unit comprising an electrical device according to one of Claims 1 to 9, in particular a ballast for fluorescent lamps, having a housing (1), which has two parallel side walls, and having a connection terminal (2) having a plurality of terminal connections (3) for connecting a plurality of wires and a lamp trough provided with a trough base (11), in particular according to one of Claims 10 to 12, **characterized in that** the trough base (11) of the lamp trough has an upright earthing spike (15) consisting of an electrically conductive material, and the earthing spike (15) is connected to an earthing connection (16) of the connection terminal (2).

14. Unit according to Claim 13, **characterized in that** the earthing connection (16) of the connection terminal (2) is in the form of an insulation displacement contact.

15. Unit according to Claim 13 or 14, **characterized in that** the earthing spike (15) and the trough base (11) of the lamp trough are of integral design, and the earthing spike (15) is partially stamped and bent out of the trough base (11) of the lamp trough.

16. Unit according to one of Claims 13 to 15, **characterized in that** the earthing spike (15) is electrically connected to the housing (1), in particular to the housing base of the housing (1).

17. Unit according to Claim 16, **characterized in that** the earthing spike (15) is passed in an electrically conductive manner through a cutout provided in the housing base of the housing (1).

## Revendications

1. Appareil électrique, notamment ballast pour lampes fluorescentes, comprenant un boîtier (1) présentant deux paroi latérales parallèles l'une à l'autre et comprenant un bornier de raccordement (2) à plusieurs points de connexion (3) pour raccorder plusieurs fils, **caractérisé en ce qu'**il est prévu un élément d'enclenchement (5), que l'élément d'enclenchement (5) présent deux branches d'enclenchement (6) et le bornier de raccordement (2) est fixé dans le boîtier (1) au moyen de l'élément d'enclenchement (5), le bornier de raccordement (2) étant en fait relié avec l'élément d'enclenchement (5) au moyen de la branche d'enclenchement (6) et l'élément d'enclenchement (5) avec le boîtier (1) au moyen de la même branche d'enclenchement (6), un creux (7) étant à chaque fois prévu dans les deux parois latérales du boîtier (1) et les deux branches d'enclenchement (6) étant respectivement enclenchés dans un creux (7).

2. Appareil électrique selon la revendication 1, **caractérisé en ce que** le bornier de raccordement (2) présente un fond, les branches d'enclenchement (6) de l'élément d'enclenchement (5) présentent un tenon dirigé vers l'intérieur et le fond du bornier de raccordement (2) est recouvert latéralement par le tenon de la branche d'enclenchement (6).

3. Appareil électrique selon la revendication 1 au 2, **caractérisé en ce que** les deux branches d'enclenchement (6) présentent à chaque fois un tenon dirigé vers l'intérieur et le fond du bornier de raccordement (2) est recouvert latéralement par les tenons des branches d'enclenchement (6).

4. Appareil électrique selon l'une des revendications 1 à 3, **caractérisé en ce que** l'élément d'enclenchement (5) présente deux parois latérales (8), les deux branches d'enclenchement (6) sont à chaque fois prévues sur une paroi latérale (8) de l'élément d'enclenchement (5) et les parois latérales (8) sont reliées entre elles par une paroi avant (9) au niveau du côté avant de l'élément d'enclenchement (5).

5. Appareil électrique selon la revendication 4, **caractérisé en ce que** le côté arrière de l'élément d'enclenchement (5) est ouvert.

6. Appareil électrique selon la revendication 4 ou 5, **caractérisé en ce que** l'élément d'enclenchement (5) présente un fond (10).

7. Appareil électrique selon l'une des revendications 1 à 6, **caractérisé en ce que** l'élément d'enclenchement (5) est constitué d'un matériau non conducteur d'électricité, notamment de matière plastique.

8. Appareil électrique selon l'une des revendications 4 à 7, **caractérisé en ce que** la paroi avant (9) et/ou le fond (10) de l'élément d'enclenchement (5) servent ou sert de protection contre l'enfichage par le dessous.

9. Appareil électrique selon l'une des revendications 1 à 8, **caractérisé en ce que** les côtés intérieurs du boîtier (1) et/ou le fond du boîtier est recouvert d'un film électriquement isolant.

10. Sous-ensemble constitué d'un appareil électrique selon l'une des revendications 1 à 9, notamment ballast pour lampes fluorescentes, comprenant un boîtier (1) présentant deux paroi latérales parallèles l'une à l'autre et comprenant un bornier de raccordement (2) à plusieurs points de connexion (3) pour raccorder plusieurs fils et un berceau de lampe muni d'un fond de berceau (11), **caractérisé en ce que** dans le fond du boîtier de l'appareil électrique est prévue une fente (12), le fond de berceau (11) du berceau de lampe présente une patte d'enclenchement (13) et la patte d'enclenchement (13) est enclenchée dans la fente (12).

11. Appareil électrique selon la revendication 10, **caractérisé en ce que** la patte d'enclenchement (13) et le fond de berceau (11) du berceau de lampe sont réalisés d'une seule pièce.

12. Appareil électrique selon la revendication 10 ou 11, **caractérisé en ce que** la patte d'enclenchement (13) est munie d'au moins une languette d'enclenchement flexible.

13. Sous-ensemble constitué d'un appareil électrique selon l'une des revendications 1 à 9, notamment ballast pour lampes fluorescentes, comprenant un boîtier (1) présentant deux paroi latérales parallèles l'une à l'autre et comprenant un bornier de raccordement (2) à plusieurs points de connexion (3) pour raccorder plusieurs fils et un berceau de lampe muni d'un fond de berceau (11), notamment selon l'une des revendications 10 à 12, **caractérisé en ce que** le fond de berceau (11) du berceau de lampe présente un picot de mise à la terre (15) disposé en haut en un matériau conducteur d'électricité et le picot de mise à la terre (15) est relié avec une borne de mise à la terre (16) du bornier de raccordement (2).

14. Sous-ensemble selon la revendication 13, **caractérisé en ce que** la borne de mise à la terre (16) du bornier de raccordement (2) est réalisée sous la forme d'un contact à cisaillement.

15. Sous-ensemble selon la revendication 13 ou 14, **caractérisé en ce que** le picot de mise à la terre (15) et le fond de berceau (11) du berceau de lampe sont réalisés d'une seule pièce et le picot de mise à la terre (15) est en partie découpé et replié hors du fond de berceau (11) du berceau de lampe.

16. Sous-ensemble selon l'une des revendications 13 à 15, **caractérisé en ce que** le picot de mise à la terre (15) est relié électriquement avec le boîtier (1), notamment avec le fond du boîtier (1).

17. Sous-ensemble selon la revendication 16, **caractérisé en ce que** le picot de mise à la terre (15) traverse de manière électriquement conductrice un creux prévu dans le fond du boîtier (1).
